# EUROPEAN PATENT APPLICATION

(11) **EP 4 604 182 A1**
(43) Date of publication of application: **20.08.2025**
(21) Application number: 23877004.4
(22) Date of filing: 23.08.2023
(51) Int. Cl.: H01L 33/00, B23K 26/36, H01L 21/02, H01L 21/304, H01L 33/08

(54) **METHOD FOR PRODUCING BONDED LIGHT-EMITTING ELEMENT WAFER**

(30) Priority: 12.10.2022 JP 2022164272
(71) Applicant: Shin-Etsu Handotai Co., Ltd., Tokyo 100-0004 (JP)
(72) Inventor: ISHIZAKI Junya, Annaka-shi, Gunma 379-0196 (JP)
(74) Representative: Schicker, Silvia
(86) International application number: PCT/JP2023/030243
(87) International publication number: WO 2024/079996

(57) **Abstract**

The present invention is a method for producing a bonded light-emitting device wafer in which a failure portion is removed, the method includes the steps of obtaining a bonded wafer by bonding a light-emitting device structure, which is to be a micro LED, to a to-be-bonded substrate transparent to laser light for LLO transfer via an adhesive that absorbs the laser light for LLO transfer, producing map data for removal by optically investigating the failure portion of the bonded wafer, and obtaining the bonded light-emitting device wafer by irradiating the failure portion of the bonded wafer with the laser light for removal based on the map data for removal, and by sublimating a portion of the light-emitting device structure that is included in the failure portion, thereby removing the portion of the light-emitting device structure that is included in the failure portion. This provides a method for producing a bonded light-emitting device wafer capable of producing the bonded light-emitting device wafer by selectively removing a failure portion of a light-emitting device structure, which serves as a micro LED bonded to a to-be-bonded wafer via the adhesive.

## Description

### TECHNICAL FIELD

The present invention relates to a method for producing a bonded light-emitting device wafer. In particular, the present invention relates to a method for producing a bonded light-emitting device wafer in which a failure portion is removed.

### BACKGROUND ART

As for a wafer for an AlGaInP-based micro LED (µ-LED), a technique of a bonded wafer in which the bonding is performed by using BCB is disclosed.

In the wafer described above, bonding-failure portions may be generated due to surface conditions on the bonded wafer and a to-be-bonded wafer, or the presence of foreign matters on an epitaxial layer or a bonding interface because wafers are bonded to each other.

In many cases, the bonding-failure portions are protrusion-shaped, which causes degrading precision of a shape and a dimension during the step of producing a device structure and, particularly, during processing by photolithography.

In addition, when transferring µ-LED dice produced from a wafer having such protrusion-shaped failure portions to a transfer destination substrate, the protrusion portions generate non-uniformity in applied pressure, which results in a transfer failure.

Consequently, when transferring devices from the wafers having bonded µ-LEDs formed thereon, it has been required to remove the failure portions in protrusion-shape before transferring the devices.

With LED dice assuming conventional discrete devices, various methods have been available to physically remove the failure portions.

For example, Patent Document 1 discloses a technique to suck and hold the dice. However, when a single plate is used to suck and hold the dice, it is assumed that all dice heights are within a range of a certain tolerance. When the bonding failure generates protrusion portions on a wafer before device production, heights of the dice after device processing are uneven. Therefore, in the prior technique disclosed here, the failures are generated during transfer. Moreover, this technique is not capable of selectively removing the failure portions because a batch transfer is applied.

Patent Document 2 discloses a technique for picking up dice by an electrostatic method, but as in Patent Document 1, the technique is based on an assumption that the dice are picked up to a single plate-shaped jig, and thus this method is not applicable when protrusion-shape portions are generated.

Patent Document 3 discloses a technique for optically detecting failures and mechanically taking out failure dice. In order to mechanically take out the failure dice, it is required that the dice have a certain size (150 µm square or more), and this technique cannot be applied to µ-LED dice having a size of less than 100 µm square.

Even if it is possible to pick up the failure dice by improving the technique in Patent Document 3, the failure portions are firmly bonded to a to-be-bonded wafer by BCB; therefore, it is impossible to mechanically pick up the failure portions while retaining the BCB portion.

Thus, the technique for selectively removing the failure portions from epitaxial layer portions for µ-LED or device-processed µ-LED dice, which is firmly bonded to the to-be-bonded wafer via the BCB, is not disclosed in Patent Documents 1 to 3.

### CITATION LIST

### PATENT LITERATURE

Patent Document 1: JP 2021-019162 A
Patent Document 2: JP 2018-163900 A
Patent Document 3: JP 5169509 B2

### SUMMARY OF INVENTION

### TECHNICAL PROBLEM

In many cases, bonding-failure portions appear as an epitaxial layer in a protrusion shape on a side from which a starting substrate has been removed when the starting substrate is removed. In particular, a size of the failure portions having the protrusion shape generated due to BCB curing failure can be as large as about 100 to 300 µm in height and about 500 to 5000 µm in diameter in width, which adversely affects photolithography. When the photolithography is performed by contact exposure, a wafer and a photomask are tightly adhered to each other in a vacuum; thus, the mask is deformed according to TTV (Total Thickness Variation: the difference between a maximum value and a minimum value of thicknesses) of the wafer. When adhesive failure portions having the protrusion shape are present, incident light from an exposure source is obliquely incident, and a pattern formed is deviated from a mask pattern, resulting in distorted, or enlarged. This causes shapes of a device, an electrode, and a protective film to deviate from designed values, and thus, a size deviation and a position deviation are generated. When such a device is transferred to a mounting substrate, the deviation is generated with a pattern on the mounting substrate side, resulting in a lowered mounting accuracy and an increased failure rate. The deviation from the designed value is difficult to detect by photoluminescence (PL) characteristics inspection or visual inspection; an abnormality is sometimes noticed only after the device is mounted and energized. When the failure is recognized after mounting, re-mounting work is required, resulting in an increase in mounting cost.

In addition, when µ-LED dice produced from such a wafer are transferred to a transfer destination substrate, the protrusion portion generates non-uniformity in applied pressure and tends to generate a transfer failure.

Moreover, an adhesive layer functions as an adhesive even in the failure portions, and the failure portions are not peeled off or exfoliated by a tensile strength of vacuum sucking or adhesion, and thus, the failure portions are maintained.

Furthermore, the failure portions are not limited to the bonding-failure portion but also include device characteristic failure portions. As in the bonding-failure portions, such device characteristic failure portions are difficult to detect by PL characteristic inspection or visual inspection; an abnormality is sometimes noticed only after the device is mounted and energized.

A problem for the present invention is to disclose a technique for selectively removing only the failure portions from the epitaxial layer portion for µ-LED or device-processed µ-LED dice, which is firmly bonded to the to-be-bonded wafer via BCB.

The present invention has been made to solve the above-described problem. An object of the present invention is to provide a method for producing a bonded light-emitting device wafer capable of producing the bonded light-emitting device wafer by selectively removing failure portions of a light-emitting device structure, which is to be a micro LED, bonded to a to-be-bonded wafer via adhesive.

### SOLUTION TO PROBLEM

To solve the above problem, the present invention provides a method for producing a bonded light-emitting device wafer in which a failure portion is removed, the method comprising the steps of:
obtaining a bonded wafer by bonding a light-emitting device structure, which is to be a micro LED, to a to-be-bonded substrate transparent to laser light for LLO transfer via an adhesive that absorbs the laser light for LLO (Laser Lift-Off) transfer;
producing map data for removal by optically investigating the failure portion of the bonded wafer; and
obtaining the bonded light-emitting device wafer by irradiating the failure portion of the bonded wafer with the laser light for removal based on the map data for removal, and by sublimating a portion of the light-emitting device structure that is included in the failure portion, thereby removing the portion of the light-emitting device structure that is included in the failure portion.

With such an inventive method for producing a bonded light-emitting device wafer, the failure portions in the light-emitting device structure included in the bonded light-emitting device wafer (for example, bonding-failure portions and device characteristic failure portions) can be selectively removed by irradiating with the laser light. Moreover, in the inventive method for producing a bonded light-emitting device wafer, the failure portions of the light-emitting device structure can be selectively removed easily without using a mechanical method. That is, according to the inventive method for producing a bonded light-emitting device wafer, the bonded light-emitting device wafer, in which the failure portions of the light-emitting device structure have been removed, can be easily produced.

It is preferable that,
in the step of producing the map data for removal,
a photoluminescence spectrum of the bonded wafer is obtained, and then a first map data for the failure portion is produced by using a peak wavelength, a peak intensity, and/or a half width of peak as criteria,
the bonded wafer is photographed from the to-be-bonded substrate with a CCD camera, and then a second map data for the failure portion is produced based on a color tone of an image obtained by the photographing,
a surface of the light-emitting device structure of the bonded wafer is irradiated with a laser light for topology detection from an oblique direction to obtain topology data and then a topology map data for the failure portion based on the topology data is produced, and
the map data for removal for the failure portion is produced by using the first map data, the second map data, and the topology map data.

By basing on the map data for removal produced in this way, all of the bonding-failure portions and the device characteristic failure portions in the light-emitting device structure included in the bonded light-emitting device wafer can be selectively and reliably removed.

When producing the map data for removal before the device isolation processing, the above topology map data can be obtained and merged with the above first map data and the above second map data to produce the map data for removal; and by performing the removal with the laser based on this map data for removal, all of the bonding-failure portions and the device characteristic failure portions in the light-emitting device structure included in the bonded light-emitting device wafer can be selectively and reliably removed. Furthermore, as a result, an accuracy-failing portion in photolithography around the failure portions of the light-emitting device structure can be reduced.

It is preferable that, after the step of obtaining the bonded light-emitting device wafer, the method further comprises a step of device isolation processing.

In this way, it is possible to easily obtain a bonded light-emitting device without the failure portion.

It is preferable that, after the step of obtaining the bonded wafer, and before the step of producing the map data for removal, the method comprises a step of device isolation processing to the light-emitting device structure of the bonded wafer.

By processing the bonded wafer that includes the light-emitting device structure isolated into the device in this way, the failure portions of the light-emitting device structure can be selectively removed easily without affecting a good portion of the light-emitting device structure.

With such a method, all of the bonding-failure portions and the device characteristic failure portions in the light-emitting device structure included in the bonded light-emitting device wafer can be selectively and reliably removed.

In this case, it is preferable that,
in the step of producing the map data for the removal,
a photoluminescence spectrum of the bonded wafer is obtained and then a first map data for the failure portion is produced by using a peak wavelength, a peak intensity, and/or a half width of peak as criteria,
the bonded wafer is photographed from the to-be-bonded substrate with a CCD camera and then a second map data for the failure portion is produced based on a color tone of an image obtained by the photographing,
a surface of dice pattern of the light-emitting device structure of the bonded wafer is photographed with a camera, and quality thereof is determined based on deviation from a base pattern to produce an appearance inspection map data,
the map data for removal for the failure portion is produced by using the first map data, the second map data, and the appearance inspection map data.

Based on the map data for removal produced in this way, after device isolation processing, all of the bonding-failure portions and the device characteristic failure portions in the light-emitting device structure included in the bonded light-emitting device wafer can be selectively and reliably removed.

It is preferable that, as the laser light for removal, a laser light having a wavelength of greater than 360 nm and 680 nm or less is used.

The laser light having a wavelength greater than 360 nm and 680 nm or less has a wavelength at which an EP layer efficiently and easily absorbs the light, and this wavelength has an extremely small absorption coefficient for layers other than the EP layer of the light-emitting device structure. Consequently, only a portion of the light-emitting device structure that is included in the failure portions can be sublimated, allowing the removal of only a portion of the light-emitting device structure that is included in the failure portions.

The laser light for removal is preferably irradiated from either the light-emitting device structure or the to-be-bonded substrate.

This enables the laser light for removal to be irradiated appropriately only on the failure portions. Consequently, only a portion of the light-emitting device structure that is included in the failure portions can be sublimated, allowing the removal of only a portion of the light-emitting device structure that is included in the failure portions.

The adhesive is preferably selected from the group consisting of benzocyclobutene, silicone resin, epoxy resin, SOG (spin-on-glass), polyimide, and amorphous fluororesin.

Such an adhesive can firmly bond the light-emitting device structure to the to-be-bonded substrate and can be easily vaporized with the laser light for LLO transfer.

It is preferred that, before removing the portion of the light-emitting device structure that is included in the failure portions, a protective material is coated on the light-emitting device structure.

Such a protective material can prevent a good portion of the light-emitting device structure, which is not to be removed, from being damaged by, e.g., a receiving jig when the bonded wafer is irradiated with the laser light.

It is preferred that, as the protective material, a protective material containing polyvinyl acetate or a protective material containing polyvinyl alcohol is used.

Such a protective material is preferable because of easy removability thereof.

### ADVANTAGEOUS EFFECTS OF INVENTION

As described above, according to the inventive method for producing a bonded light-emitting device wafer, the failure portions in the light-emitting device structure included in the bonded light-emitting device wafer can be selectively removed. That is, according to the inventive method for producing a bonded light-emitting device wafer, the bonded light-emitting device wafer that does not include the faulty light-emitting device structure can be produced.

### BRIEF DESCRIPTION OF DRAWINGS

FIG. 1 is a schematic cross-sectional view illustrating a part of a step of obtaining a bonded wafer in the first embodiment of a method for producing a bonded light-emitting device wafer according to the present invention.
FIG. 2 is a schematic cross-sectional view illustrating another part of a step of obtaining a bonded wafer in the first embodiment of a method for producing a bonded light-emitting device wafer according to the present invention.
FIG. 3 is a schematic cross-sectional view of a bonded wafer obtained in a step of obtaining the bonded wafer in the first embodiment of a method for producing a bonded light-emitting device wafer according to the present invention.
FIG. 4 is a schematic cross-sectional view illustrating a part of a step of obtaining a bonded light-emitting device wafer in the first embodiment of a method for producing a bonded light-emitting device wafer according to the present invention.
FIG. 5 is a schematic cross-sectional view illustrating irradiation of laser light for removal in the first embodiment of a method for producing a bonded light-emitting device wafer according to the present invention.
FIG. 6 is a schematic cross-sectional view of a bonded light-emitting device wafer, which is obtained after removing a portion of a light-emitting device structure that is included in failure portions in the first embodiment of a method for producing a bonded light-emitting device wafer according to the present invention.
FIG. 7 is a schematic cross-sectional view of a bonded light-emitting device wafer after device isolation processing in the first embodiment of a method for producing a bonded light-emitting device wafer according to the present invention.
FIG. 8 is a schematic cross-sectional view illustrating a part of a protective film-forming step in the first embodiment of a method for producing a bonded light-emitting device wafer according to the present invention.
FIG. 9 is a schematic cross-sectional view of a bonded light-emitting device wafer obtained in the first embodiment of a method for producing a bonded light-emitting device wafer according to the present invention.
FIG. 10A is a part of map data for removal used in the first embodiment of a method for producing a bonded light-emitting device wafer according to the present invention.
FIG. 10B is a schematic plan view illustrating irradiation of laser light for removal in the first embodiment of a method for producing a bonded light-emitting device wafer according to the present invention.
FIG. 10C is a schematic plan view of a light-emitting device structure after removing a portion of the light-emitting device structure which is included in failure portions in the first embodiment of a method for producing a bonded light-emitting device wafer according to the present invention.

### DESCRIPTION OF EMBODIMENTS

As described above, the development of a method for producing a bonded light-emitting device wafer has been desired, in which the method can selectively remove failure portions of a light-emitting device structure, which is to be a micro LED, bonded to a to-be-bonded wafer via an adhesive to produce the bonded light-emitting device wafer.

To solve the above problem, the present inventor has earnestly studied and found out that the failure portions in the light-emitting device structure included in the bonded light-emitting device wafer can be selectively removed by irradiating with laser light. This finding has led to the completion of the present invention.

That is, the present invention is a method for producing a bonded light-emitting device wafer in which a failure portion is removed, the method comprising the steps of:
obtaining a bonded wafer by bonding a light-emitting device structure, which is to be a micro LED, to a to-be-bonded substrate transparent to laser light for LLO transfer via an adhesive that absorbs the laser light for LLO transfer;
producing map data for removal by optically investigating the failure portion of the bonded wafer; and
obtaining the bonded light-emitting device wafer by irradiating the failure portion of the bonded wafer with the laser light for removal based on the map data for removal, and by sublimating a portion of the light-emitting device structure that is included in the failure portion, thereby removing the portion of the light-emitting device structure that is included in the failure portion.

Hereinafter, the present invention will be described in detail with reference to the drawings. However, the present invention is not limited thereto.

### [Method for Producing Bonded Light-emitting Device Wafer]

The method for producing a bonded light-emitting device wafer according to the present invention is a method for producing a bonded light-emitting device wafer in which a failure portion is removed, the method includes the steps of obtaining a bonded wafer by bonding a light-emitting device structure, which is to be a micro LED, to a to-be-bonded substrate transparent to laser light for LLO transfer via an adhesive that absorbs the laser light for LLO transfer, producing map data for removal by optically investigating failure portions of the bonded wafer, and obtaining the bonded light-emitting device wafer by irradiating the failure portions of the bonded wafer with the laser light for removal based on the map data for removal, and by sublimating a portion of the light-emitting device structure that is included in the failure portions, thereby removing the portion of the light-emitting device structure that is included in the failure portions.

Hereinafter, such a method for producing a bonded light-emitting device wafer will be described with more detailed specific examples.

### (First Embodiment)

### <Step of Obtaining Bonded Wafer>

First, the step of obtaining a bonded wafer in this embodiment is described.

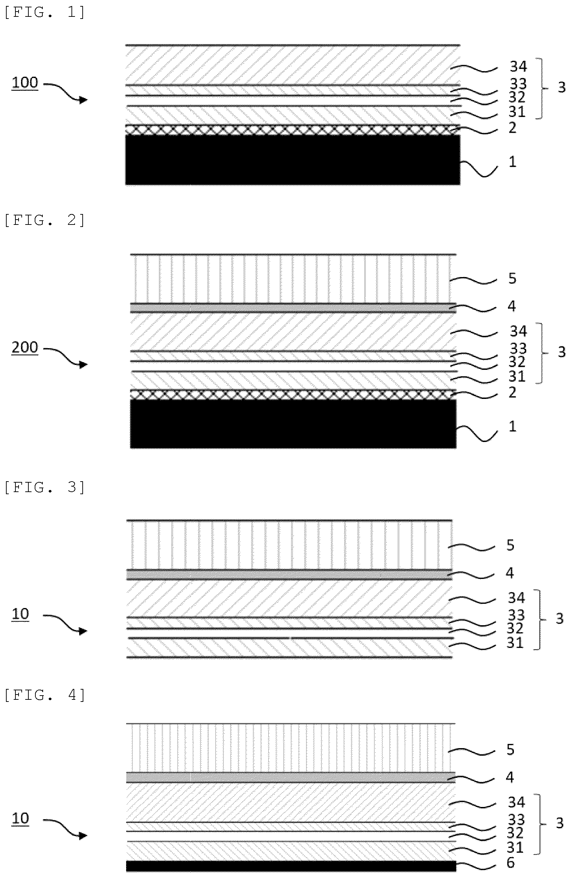

First, on a first conductivity-type GaAs substrate (starting substrate) 1 shown in FIG. 1, a first conductivity-type GaAs buffer layer (not shown) is stacked, then a first conductivity-type GaₓIn₁₋ₓP (0.4 ≤ x ≤ 0.6) first etching stop layer having a thickness of 0.1 µm, and a first conductivity-type GaAs second etching stop layer having a thickness of 0.1 µm are sequentially grown to form an etching stop layer 2. Subsequently, as shown in FIG. 1, on the etching stop layer 2, a first conductivity-type (Al_{y}Ga_{1-y})ₓIn₁₋ₓP (0.4 ≤ x ≤ 0.6, 0.6 ≤ y ≤ 1.0) first cladding layer 31 having a thickness of 1.0 µm, a non-doped (Al_{y}Ga_{1-y})ₓIn₁₋ₓP (0.4 ≤ x ≤ 0.6, 0 ≤ y ≤0.5) active layer 32 having a thickness of 0.6 µm, a second conductivity-type (Al_{y}Ga_{1-y})ₓIn₁₋ₓP (0.4 ≤ x ≤ 0.6, 0.6 ≤ y ≤ 1.0) second cladding layer 33 having a thickness of 1.0 µm, a second conductivity-type GaₓIn₁₋ₓP (0.5 ≤ x ≤ 1.0) intermediate layer (not shown) having a thickness of 0.1 µm, and a second conductivity-type GaP window layer 34 are sequentially grown to provide an EPW (epitaxial wafer) 100 having a light-emitting device structure 3 as an epitaxial functional layer. Here, the first cladding layer 31 to the second cladding layer 33 are referred to as a DH structure portion. Moreover, the light-emitting device structure 3 is to be processed to the device (dice), being a to-be-micro LED, by processing in a later stage.

The film thicknesses exemplified above are just examples, and the film thickness is no more than a parameter to be changed according to the operating specifications of the device; therefore, it is needless to say that the film thickness is not limited to the thicknesses described here. Moreover, it is needless to say that each layer is not a single composition layer but conceptually includes a plurality of composition layers within the exemplified composition range. Furthermore, it is needless to say that the carrier concentration level is not uniform in each layer but conceptually includes a plurality of levels in each layer.

The active layer 32 may be composed of a single composition or may have the structure where a plurality of barrier layers and active layers are alternatively stacked, it is needless to say that the same function can be exhibited in each case and it is needless to say that any one of the both cases can be selected.

Subsequently, as an adhesive (thermosetting bonding material), benzocyclobutene (BCB) 4 is spin-coated on the EPW 100, and then the light-emitting device structure 3 and a sapphire wafer, being the to-be-bonded substrate 5, are superimposed facing each other via the adhesive 4 and then thermocompression-bonding is performed. Thereby, an EPW bonded substrate 200 is produced, in which the light-emitting device structure 3 of the EPW 100 and the sapphire wafer 5 are bonded to each other via the BCB 4, as shown in FIG. 2.

Although the to-be-bonded substrate 5 is exemplified as sapphire in this embodiment, it is needless to say that the to-be-bonded substrate 5 is not limited to sapphire, and any material can be selected as long as transparency to laser light for LLO described later and flatness are guaranteed. Quartz can be selected instead of sapphire.

In this embodiment, a case where the BCB 4 is in a state of being coated in a layered shape is exemplified, but it is needless to say that the adhesive 4 is not limited to the layered shape. It is needless to say that the same result can be obtained by patterning photosensitive BCB to an isolated island shape, a line shape, or other shapes, and then by performing a bonding step.

Next, the GaAs starting substrate 1 is removed by wet etching to expose the first etching stop layer; the etchant is then switched, and the second etching stop layer is removed. The etching stop layer 2 is removed and the first cladding layer 31 is exposed in this manner to produce a bonded wafer (EP bonded substrate) 10, in which the light-emitting device structure 3, including the DH layer and the window layer 34, and the to-be-bonded substrate 5 are bonded each other via the adhesive 4, as shown in FIG. 3.

For example, the spin-coating is used for coating BCB.

A thickness of the adhesive 4 or a designed film thickness of a layer of BCB 4 is preferably 0.1 to 2 µm. For example, the thickness thereof can be 0.6 µm. This allows firm and sufficient adhesion. A thickness of 0.1 µm or more is preferable as thickness control is easy and a bonding yield is improved. When the thickness is set to 2 µm or less, it is preferable because a crown is less likely generated, and exfoliation and removal of BCB can be performed in a shorter processing time during the laser lift-off (LLO) step for micro LED mounting.

### <Step of Producing Map Data for Removal>

Next, the step of producing map data for removal is performed by optically investigating the failure portions of the bonded wafer 10.

In this embodiment, a first map data for the failure portions, a topology map data for the failure portions, and a second map data for the failure portions are produced, and then the map data for removal for the failure portions is produced by using these map data.

Hereinafter, the obtainment of respective map data is described.

### [First Map Data]

First, an entire region of the bonded wafer 10 is irradiated with a laser having a wavelength of 325 to 532 nm and a spot diameter of 100 µm at a pitch of 25 µm, from the EP layer side, and photoluminescence (PL) spectrum is collected to produce the first map data. Any of the wavelengths described above can be selected for the wavelength of the laser, but a solid-state laser having an emission wavelength of 532 nm is used in this embodiment.

In this embodiment, a case where the laser irradiation is irradiated from the EP layer side is exemplified, but it is not limited to a form in which the laser is irradiated from the EP layer, and it is needless to say that the same data can be obtained when the laser is irradiated through a sapphire substrate.

In this embodiment, a dominant wavelength of the EPW 100 during EL emission is designed to be 632 nm, a position within a range of 632 ± 5 nm is determined as a passing grade and a position within another wavelength region is determined as a failing grade, and then the first map data for the failure portions, especially for the device-characteristics-failure portions is produced.

Although the wavelength is exemplified as an investigation item for the failure portions in this embodiment, it is needless to say that criteria are not limited to the wavelength. Due to deformation, stress is often applied to protrusion-shaped failure portions and a crack may be generated. Because the half-width of peak is increased due to high stress, and PL intensity is significantly decreased due to a generation of the crack, the first map data may be produced using the PL intensity or the half-width as the criteria, or as additional criteria. Whether to prioritize intensity, wavelength, or half-width or to determine thereof based on OR conditions rather than AND conditions, is a matter of design choice, and it is needless to say that these conditions are merely conditions that can be determined according to the bonding state.

### [Topology Map Data]

A surface of the light-emitting device structure 3 of the bonded wafer 10 shown in FIG. 3 is irradiated with a laser having an emission wavelength of 532 nm from an oblique direction. In a system having a photodetector arranged at a position in reflection direction at the same angle as laser incident angle, an entire surface of the wafer is irradiated with a laser at a pitch of 25 µm, and deviation of reflection angle is measured. The reflection angle is deviated upward at a protrusion portion of the light-emitting device structure 3, and the reflection angle is deviated downward at an indentation portion; therefore, the topology data are collected from the deviations of the reflection angles. The topology map data are produced using height tolerance as a threshold where a point within the tolerance is determined as a passing grade, and a point other than that is determined as a failing grade.

### [Second Map Data]

The bonded wafer 10 in FIG. 3 is photographed from the to-be-bonded substrate (sapphire substrate) 5 with a CCD camera, and a passing grade and a failing grade are determined based on a color tone. The failing grade marked as the bonding failure tends to be the color tone slightly whiter (lighter) than the point with uniform bonding, and pass or fail is decided based on a difference in contrast; the second map data is then produced regarding the failure portions, especially the bonding-failure portions, in which the pass or fail is determined at 25 µm pitch mesh.

The failure portions of the first map data, the topology map data, and the second map data obtained as described above are superimposed to produce the map data for removal. Although the respective positions of the three types of map meshes do not match each other, any region defined as failure portions in any one type of the map is defined as failure portions, and then the map data for removal is produced.

### <Step of Irradiating Failure Portion of Bonded Wafer with Laser Light for Removal based on Map Data for Removal, thereby Removing Portion of Light-Emitting Device Structure that is included in Failure Portion to obtain Bonded Light-Emitting Device Wafer>

In this step, the bonded light-emitting device wafer is obtained by a procedure described below.

First, as shown in FIG. 4, a protective material 6 is coated on a surface of the bonded wafer 10 from which the starting substrate has been removed.

In this embodiment, HogoMax (registered trademark: propylene glycol monomethyl ether and polyvinyl alcohol are contained according to SDS) manufactured by DISCO Corporation can be exemplified as the protective material 6. The material of the protective material 6 is not limited to HogoMax, and any material that has a function of the protective material and is easily removable can be selected. Other than HogoMax, for example, polyvinyl acetate and polyvinyl alcohol are also suitable.

The protective material 6 is coated by spin-coating.

The bonded wafer (EP bonded substrate) 10 coated with the protective material 6 is introduced into a laser processing unit, a surface of the EP layer is irradiated with the laser according to the map data for removal to ablation-remove the failure portions, as follows.

The bonded wafer 10 coated with the protective material 6 is introduced into the laser processing unit. When introducing the wafer, for example, the bonded wafer 10 is held by a bonded-wafer-receiving jig, and introduced in the laser processing unit. The bonded-wafer-receiving jig is provided with an opening region in the center, and a periphery of the opening region serves as a wafer-receiving-groove portion. When holding the wafer, the light-emitting device structure is made to be located at the opening region.

Moreover, when introducing the bonded wafer 10, the introduction is performed with a coated surface of the protective material 6 facing upward. Although a case where the coated surface of the protective material 6 facing upward is exemplified in this embodiment, the case is not limited to the state of facing upward; it is needless to say that the coated surface may be set facing downward or side. However, when facing upward, the laser ablation processing apparatus generally has a structure in which a laser irradiation port is arranged on the upper side (ceiling direction) of a substrate introducing portion (wafer setting portion). This allows an arrangement of the laser for removal (ablation laser) and the substrate introducing portion in the apparatus in the same manner as in a conventional apparatus, making design easier and enabling the use of existing apparatuses, which is advantageous.

Next, the region defined as the failure portion is irradiated with the laser for removal from the light-emitting device structure 3 of the bonded wafer 10 based on the map data for removal obtained earlier.

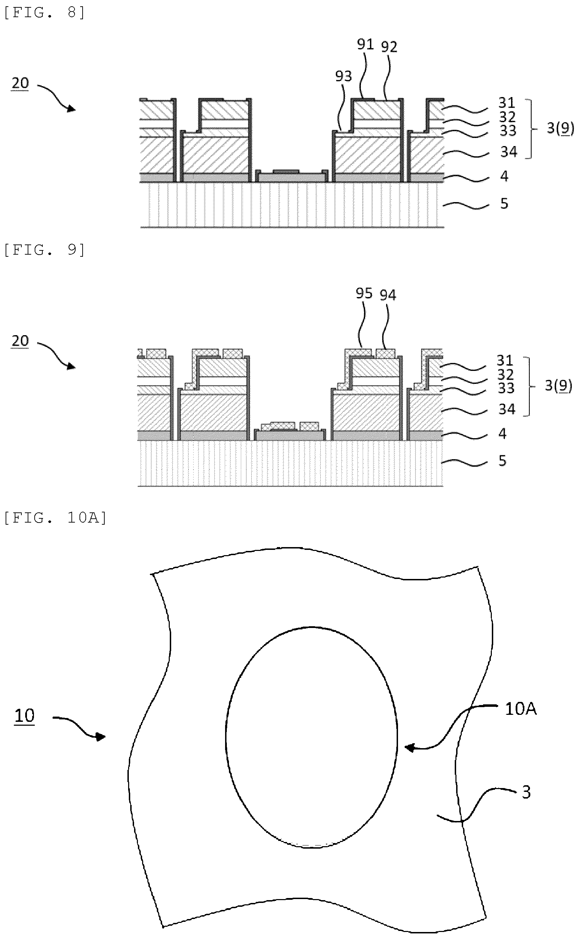

FIG. 10A shows a part of an example of the map data for removal. The map data for removal shown in FIG. 10A shows a failure portion 10A of the bonded wafer 10 at the center. The failure portion 10A includes the failure portions of the light-emitting device structure 3.

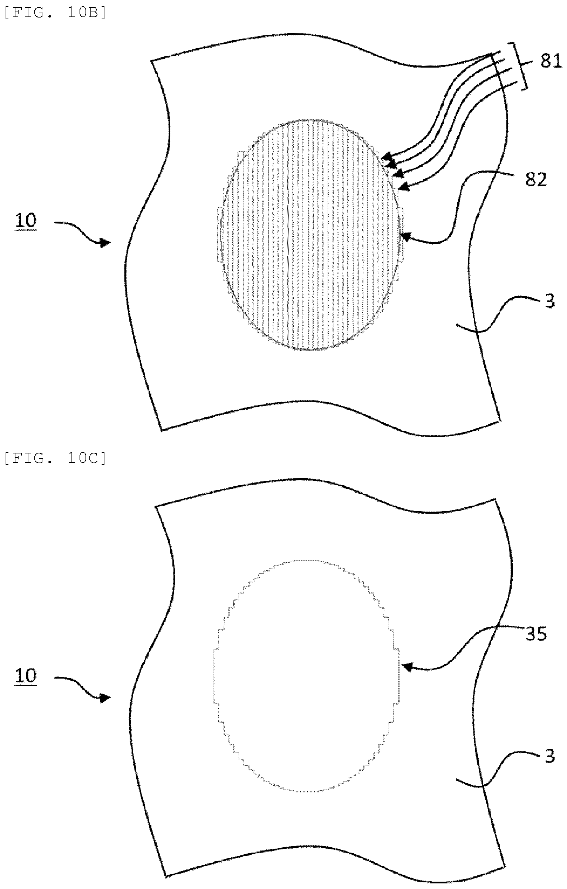

This failure portion 10A is irradiated with the laser light for removal a plurality of times as shown in FIG. 10B, in this embodiment. As a result, a plurality of laser irradiation areas (per occurrence) 81 are generated, and as a whole, a laser irradiation region 82 that can be referred to as almost exclusively failure portion 10A is generated. In another aspect, all of the failure portion 10A (failure portion of light-emitting device structure 3 is included) of the bonded wafer 10 can be irradiated with the laser light for removal.

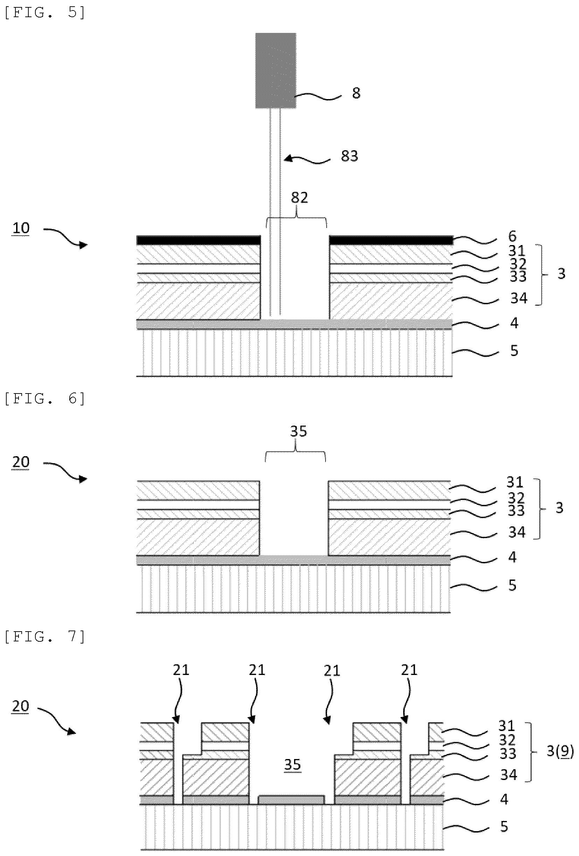

FIG. 5 shows a state in which the laser light 83 for removal radiated from a laser head 8 is irradiated from the light-emitting device structure 3 side; the laser light 83 for removal is absorbed by a portion of the light-emitting device structure 3 included in the failure portion 10A of the bonded wafer 10; a portion of the light-emitting device structure 3 included in the failure portion 10A is sublimated and dissipated in a gaseous body; and then the protrusion-shaped failure portions of the light-emitting device structure 3 are eliminated. The failure portions are mostly eliminated along a laser irradiation direction; therefore, an impact on adjacent good portions in the light-emitting device structure 3 can be minimized.

That is, portions (failure portions) of the light-emitting device structure 3, which are included in the failure portion 10A of the bonded wafer 10, can be removed by irradiating the failure portion 10A of the bonded wafer 10 with the laser light for removal.

In this embodiment, a case in which the EP layer surface is irradiated with the laser is exemplified, but the case is not limited to irradiation of the EP layer surface. It is needless to say that the same effect can be obtained when irradiating from the sapphire substrate which does not absorb light against the laser light. Note that the wavelength of the laser light for removal is mostly not absorbed in adhesive 4.

The laser light (visible light) having a wavelength of greater than 360 nm and 680 nm or less can be used for the laser light 83 for removal. For example, an Ar⁺ excimer laser having a wavelength of 514.5 nm is used.

The laser light having a wavelength of greater than 360 nm and 680 nm or less has a wavelength that is easily and efficiently absorbed by the EP layer. This wavelength has an extremely small absorption coefficient for portions other than the EP layer of the light-emitting device structure; therefore, only the portion of the light-emitting device structure that is included in the failure portions can be sublimated, and this allows the removal of only the portion of the light-emitting device structure that is included in the failure portions.

Regarding a difference between the laser light 83 for removal and laser light for PL mapping or topology mapping measurements, laser outputs have a difference. When the laser light 83 for removal as in this embodiment is a CW (continuous wave) laser, a density after condensation is generally 100 mW/cm² to 100 TW/cm². Under conditions where energy density exceeds 10kW/cm², a temperature of the EP layer rises excessively, thus in the PL or the topology measurements, the measurements are performed using a low-power laser having an output of 1 kW/cm² or less.

FIG. 10B, as described earlier, is a conceptual diagram showing when the bonding-failure portion is removed by the laser light for removal described above. Regarding laser light for removal, the removal area (portion of light-emitting device structure 3 that is included in failure portion 10A of bonded wafer 10) is irradiated with laser light along a profile, as shown in FIG. 10B. After the laser irradiation, a region 35 having a minimum area from which the failure potion has been removed can be obtained as shown in FIG. 10C. In other words, all failure portions can be removed with a small excess which can be referred to as almost the failure portions.

After irradiating the laser, the bonding failure area can be removed with a minimum area as shown in FIG. 10C. An area covering slightly outside the laserirradiated area is ablated and removed by the laser irradiation, but a boundary portion of the removal by ablation is determined by heat transfer in the EP layer, resulting in a width of a few µm or less than 10 µm from the irradiation area. The failure portions are removed from the EP layer portion and thus become a concave portion on the EP layer surface.

Subsequently, the bonded wafer 10 is taken out from the laser processing unit and is cleaned with pure water while facing the coated surface of the protective material 6 downward to remove the protective material 6. As a result, a bonded light-emitting device wafer 20 can be obtained, in which light-emitting device structure 3, including the region 35 where the failure potion has been removed, and the to-be-bonded substrate 5 are bonded via the adhesive 4, as shown in FIG. 6. The wafer before removing the protective material 6 can also be referred to as the bonded light-emitting device wafer. The debris generated during the ablation treatment is present on the protective material and is removed from the surface of the EP layer along with the protective material during the cleaning process.

The light-emitting device structure 3 is a structure to be a micro LED and can be subjected to, for example, device isolation processing, as shown below. An example of processing is described below.

A mask pattern is formed on the light-emitting device structure 3 by a photolithography method, and the light-emitting device structure 3 is subjected to device isolation processing by ICP. With this process, the light-emitting device structure 3 is formed into devices (light-emitting device structures subjected to device isolation processing, i.e., dice) 9 isolated by isolation grooves 21, as shown in FIG. 7. Gases used for the ICP are, for example, chlorine and argon. The ICP processing is performed twice: for example, a step of exposing the to-be-bonded substrate 5 and a step of exposing a part of a main surface of the second cladding layer 33.

Although a case where a part of the main surface of the second cladding layer 33 is exposed is exemplified in this embodiment, it is needless to say that the case is not limited to the case where a part of the main surface of the second cladding layer 33 is exposed. It is needless to say that a purpose of processing can be achieved when an active layer 32 is, at least, isolated. It is needless to say that the same effect can be obtained even when a part of a main surface of the GaP window layer 34 is exposed instead of the exposure of the second cladding layer 33.

After device isolation processing, a protective film 91 is formed as end face processing, as shown in FIG. 8. In this embodiment, SiO₂ is used as the protective film 91. The protective film 91 is not limited to SiO₂, but any material can be selected as long as the end face can be protected and the material has insulating properties. SiNₓ, titanium oxide, magnesium oxide, etc., can also be selected. The protective film 91 is provided with an opening 92 that exposes a part of a main surface of the first cladding layer 31 and an opening 93 that exposes a part of the main surface of the second cladding layer 33.

Following the formation of the protective film 91, as shown in FIG. 9, electrodes 94 and 95 are formed in contact with the first conductivity-type layer and the second conductive-type layer, respectively, and ohmic contact is then formed by performing heat treatment. In this embodiment, the first conductivity-type is designed as N-type, and the second conductivity-type is designed as P-type; metals containing Au and Si are used for the N-type electrode 94 in contact with the first cladding layer 31 which is the N-type layer through the opening 92, and metals containing Au and Be are used for the P-type electrode 95 in contact with the second cladding layer 33 which is the P-type layer through the opening 93.

In this embodiment, although the metals of Au and Si are used for the N-type electrode, it is needless to say that the material thereof is not limited to these, but the same result can be obtained by using the metals containing Au and Ge. Moreover, the metals of Au and Be are used for the P-type electrode, but it is needless to say that the material thereof is not limited to these, and the same result can be obtained even when the metals containing Au and Zn are used.

Moreover, the BCB is used as the adhesive 4 in this embodiment, but the material of the adhesive 4 used in the present invention is not limited to the BCB. For example, when using the to-be-bonded substrate 5 that is transparent to the laser light for LLO transfer having a wavelength of 170 nm or more and 360 nm or less, if the adhesive 4 has an optical absorption edge in a wavelength region of 170 nm or more and 360 nm or less, the adhesive can be easily sublimated with the laser light for LLO transfer having a wavelength of 170 nm or more and 360 nm or less that can transmit through the to-be-bonded substrate 5. Examples of the adhesive 4 can include silicone resin, epoxy resin, SOG, polyimide, and amorphous fluororesin (e.g., CYTOP (registered trademark)) in addition to BCB, and by using these, the light-emitting device structure 3 and the to-be-bonded substrate 5 can be firmly bonded.

### (Second Embodiment)

In the second embodiment, the step for obtaining a bonded wafer 10 is the same as in the first embodiment, but the second embodiment is different from the first embodiment in that device isolation processing and electrode formation processing to a light-emitting device structure 3 are performed before the step of obtaining a map data for removal.

The device isolation processing and the electrode formation processing can be performed in the same procedure as described with reference to FIGS. 7 to 9, except that failure portions of the light-emitting device structure 3 are not taken out. In the second embodiment, the device isolation (dice) processing and the electrode attachment are performed while the protrusion-shaped failure portions are present on the light-emitting device structure 3, consequently, a device having a faulty shape and size may be formed in the failure portions. Such failure portions are removed later by irradiating with a laser for removal based on the map data for removal.

However, unlike the first embodiment, a laser is irradiated only from a sapphire substrate to produce PL map data. This is because irradiation from an opposite side is difficult due to presence of a device pattern (electrode) .

Moreover, in the second embodiment, unlike the first embodiment, the second embodiment is unsuitable for obtaining topology map data as dicing processing has been already performed. Thus, instead of topology map data, a surface of dice pattern is photographed by a camera, and quality is determined based on deviation (foreign object or size abnormality) from a basic pattern to produce an appearance inspection map data.

Subsequently, in the same way as in the first embodiment, the failure portions are overlapped each other using the first map data, the second map data, and the appearance inspection map data to produce the map data for removal.

When removing the failure portions, a protective material is coated on a surface of a device obtained by device-isolating the light-emitting device structure of the bonded wafer as in the first embodiment. Subsequently, in the same procedure as in the first embodiment, the failure portions are irradiated with a laser from a sapphire substrate and removed. The protective material is then cleaned with water and removed in the same way as in the first embodiment. In this way, a bonded light-emitting device wafer can be obtained, in which the light-emitting device structure (device) from which the failure portions have been removed and the to-be-bonded substrate are bonded to each other via the adhesive.

According to the inventive method for producing a bonded light-emitting device wafer described above, the failure portions of the light-emitting device structure can be selectively removed easily without using a mechanical method and without affecting a good portion (e.g., another dice region) of the light-emitting device structure. Moreover, according to the present invention, all portions of the light-emitting device structure that are included in the failure portions of the bonded wafer can be removed.

In particular, as in the first embodiment, accuracy-failing portions in photolithography around the failure portions can be reduced by removing a bonding-failure portions (in particular, protrusion-shaped failure portions) before initiating device processing such as device isolation processing.

Moreover, in the second embodiment, the failure portions of the light-emitting device structure can be selectively removed easily without using a mechanical method and without affecting good portions (e.g., another dice region) of the light-emitting device structure.

Note that, in the second embodiment, although a step is exemplified where the device structure is produced, followed by pass or fail determination and removal of the failure portions, it is needless to say that the removal of the failure portions is not limited to being performed only after the device structure has been completely produced. In other words, it is needless to say that the same effect can be obtained even when the step is performed after the device has been isolated or after a protective film has been formed.

As described above, in the inventive method for producing a bonded light-emitting device wafer, the failure portions in the light-emitting device structure included in the bonded light-emitting device wafer (for example, bonding-failure portions and device characteristic failure portions) can be selectively removed; as a result, the bonded light-emitting device wafer including the light-emitting device structure from which the failure portions have been removed can be produced.

### EXAMPLE

Hereinafter, the present invention will be specifically described with reference to Examples and Comparative Example. However, the present invention is not limited thereto.

### (First Example)

In First Example, a bonded light-emitting device wafer was produced in the same way as in the first embodiment described earlier. Specifically, the following is the case.

First, an EPW 100 having an EPW structure shown in FIG. 1 was obtained using the same procedure described earlier.

Next, BCB 4 was coated by spin-coating on a light-emitting device structure 3 of the EPW 100 by setting a designed film thickness of 0.6 µm.

This EPW was superimposed with a sapphire wafer, being a to-be-bonded wafer 5, facing each other, and thermocompression-bonded thereto to produce an EPW bonded substrate 200 (FIG. 2).

Next, a GaAs starting substrate 1 was removed by wet etching to expose a first etching stop layer, and an etchant was then switched to remove a second etching stop layer. As a result, an etching stop layer 2 is removed to expose a first cladding layer 31, thereby producing a bonded wafer (EP bonded substrate) 10 (FIG. 3) in which a light-emitting device structure 3, including a DH layer and a window layer 34, was bonded to a to-be-bonded substrate 5 via an adhesive 4.

Next, a map data for removal was produced by the following procedure.

An entire region of the bonded wafer 10 was irradiated with a laser having a wavelength of 532 nm and a spot diameter of 100 µm at a pitch of 25 µm, and PL spectrum was collected and a map data was produced. In this Example, a designed wavelength of EPW was designed to 632 nm, and a position within a range of 632 ± 5 nm was determined as a passing grade, and a position within another wavelength region was determined as a failing grade, and then the first map data was produced.

Moreover, a surface of the light-emitting device structure 3 of the bonded wafer 10 was irradiated with a laser having an emission wavelength of 532 nm from an oblique direction. In a system having a photodetector arranged at a position in reflection direction at the same angle as laser incident angle, an entire surface of the wafer was irradiated with the laser at a pitch of 25 µm, and topology data were collected. By using height tolerance as a threshold, the topology map data were produced where a point within the tolerance was determined as a passing grade, and a point other than that was determined as a failing grade.

Moreover, the bonded wafer 10 was photographed from a sapphire substrate 5 with a CCD camera, and a second map data, in which pass or fail was judged based on contrast difference at 25 µm pitch mesh, was produced.

The failure portions of the first map data, the topology map data, and the second map data obtained as above were superimposed to produce the map data for removal.

Next, a surface of the light-emitting device structure 3 of the bonded wafer 10, from which the starting substrate had been removed, was coated with HogoMax (registered trademark) manufactured by DISCO Corporation as a protective material 6 by spin-coating as shown in FIG. 4.

The bonded wafer 10 coated with the protective material 6 was held by a bonded-wafer-receiving jig and introduced into the laser processing unit with the coated surface of the protective material 6 facing up. In this way, the wafer was held such that the wafer-receiving groove portion of the jig overlapped with the edge portion of the sapphire substrate 5.

In the laser processing unit, as shown in FIGS. 5 and 10B, the only region defined as a failure portion 10A (and a small excess that can be referred to be the almost failure portion) was irradiated from the light-emitting device structure 3 with Ar⁺ excimer laser having a wavelength of 514.5 nm based on the map data for removal to remove the failure portions.

Subsequently, the wafer was taken out from the laser processing unit and cleaned with pure water while facing the coated surface of the protective material 6 upward to remove the protective material 6 as shown in FIG. 6.

A mask pattern was then formed on the light-emitting device structure 3 by a photolithography method and device isolation processing was performed by ICP using chlorine and argon gases. The ICP processing was performed twice: a step of exposing the to-be-bonded substrate 5 and a step of exposing a part of a main surface of the second cladding layer 33. By virtue of this device isolation processing, as shown in FIG. 7, the light-emitting device structure 3 was processed to be devices (light-emitting device structures having been subjected to device isolation processing) 9 being isolated by isolation grooves 21.

After device isolation processing, as shown in FIG. 8, an SiO₂ protective film 91 was formed as end face processing, and the protective film 91 was provided with an opening 92 that exposed a part of a main surface of the first cladding layer 31 and an opening 93 that exposed a part of the main surface of the second cladding layer 33.

Following the formation of the protective film 91, as shown in FIG. 9, electrodes 94 and 95 were formed in contact with the first conductivity-type layer and the second conductive-type layer, respectively, and ohmic contact was then formed by performing heat treatment. In this Example, the first conductivity-type was designed as N-type, and the second conductivity-type was designed as P-type; metals containing Au and Si were used for the N-type electrode 94 in contact with the first cladding layer 31 which was the N-type layer, and metals containing Au and Be were used for the P-type electrode 95 in contact with the second cladding layer 33 which was the P-type layer.

Thus, a bonded light-emitting device wafer 20 of First Example having a structure shown in FIG. 9 was obtained.

### (Second Example)

In Second Example, a bonded light-emitting device wafer was produced in the same procedure as in the second embodiment described earlier.

That is, in Second Example, the bonded light-emitting device wafer of Second Example was produced in the same way as in First Example, except that device isolation processing and electrode formation processing to a light-emitting device structure 3 were performed before a step of obtaining a map data for removal, and appearance inspection map data was obtained instead of a topology map data.

### (Comparative Example)

In Comparative Example, a bonded light-emitting device wafer of Comparative Example was produced in the same way as in First Example, except that failure portions of a light-emitting device structure were not removed.

That is, in Comparative Example, the step of obtaining a bonded wafer 10 was performed in the same way as in First Example, moreover, device isolation processing and electrode formation processing were performed in the same way as in Second Example. However, in Comparative Example, unlike Second Example, production of map data and removal of the failure portions were not performed, leaving the failure portions of the light-emitting device structure intact.

### (Evaluation)

A table comparing the removal rate of protrusion-shaped failure portions and the yield of a number of dice that did not cause problems during mounting in the end is shown below as Table 1.

**[Table 1]**

| | First Example | Second Example | Comparative Example |
|---|---|---|---|
| Removal Rate of Failure Portion | 101.2% | 100.0% | 0.00% |
| Yield of Mountable Dice | 91.2% (74.6 to 96.1%) | 93.2% (75.9 to 95.1%) | 77.6% (74.2 to 78.7%) |

In First Example, when the protrusion-shaped failure portions were removed, the failure portions and the good portions were connected to each other due to a state of wafer, and thus when the light-emitting device structures of the failure portions were sublimated, melted portions were generated due to heat transfer to adjacent good portions, which slightly caused the removal rate to exceed 100%.

In the case of Second Example, the failure portions were removed in dice state, thus, when the light-emitting device structure was sublimated, heat transfer stopped at the isolation groove between the dice, preventing the melt from propagating to the adjacent good portions. As a result, the removal rate was 100% because of a recognized failure region (dice region) and the region to be removed being approximately matched with each other.

In the case of Comparative Example, the removal rate was 0% because no removal was performed.

Table 1 above shows the yield of the mounted dice when ten bonded light-emitting device wafers, obtained by each of the methods of the First and Second Examples and Comparative Example, were introduced during the step of mounting (transferring).

Figures in parentheses are variations of 10 wafers and figures outside parentheses are average values.

The ten bonded wafers were introduced in the step of mounting, and the failure portions were then treated in First or Second Example, the yield of the number of problem-free dice was over 90% when the wafers were introduced in the step of mounting (transferring).

In contrast, in Comparative Example, the failure was likely to be generated when the dice were picked up due to the widened protrusion-shaped portions, and a number of yield of dice being mounted was decreased due to the problems such as removal failure during the failure portion removal and damage to the dice around the failure portions, resulting in about 20% decrease in yield.

As shown above, the eventual mounting yield can be improved in First Example and Second Example, where the failure portions are removed before transferring the dice to the transfer destination substrate, and the wafer is then introduced in mounting processing.

The present description includes the following embodiments.
[1]: A method for producing a bonded light-emitting device wafer in which a failure portion is removed, the method comprising the steps of:
   obtaining a bonded wafer by bonding a light-emitting device structure, which is to be a micro LED, to a to-be-bonded substrate transparent to laser light for LLO transfer via an adhesive that absorbs the laser light for LLO transfer;
   producing map data for removal by optically investigating the failure portion of the bonded wafer; and
   obtaining the bonded light-emitting device wafer by irradiating the failure portion of the bonded wafer with the laser light for removal based on the map data for removal, and by sublimating a portion of the light-emitting device structure that is included in the failure portion, thereby removing the portion of the light-emitting device structure that is included in the failure portion.
[2]: The method for producing a bonded light-emitting device wafer according to [1], wherein
   in the step of producing the map data for removal,
   a photoluminescence spectrum of the bonded wafer is obtained and then a first map data for the failure portion is produced by using a peak wavelength, a peak intensity, and/or a half width of peak as criteria,
   the bonded wafer is photographed from the to-be-bonded substrate with a CCD camera and then a second map data for the failure portion is produced based on a color tone of an image obtained by the photographing,
   a surface of the light-emitting device structure of the bonded wafer is irradiated with a laser light for topology detection from an oblique direction to obtain topology data and then a topology map data for the failure portion based on the topology data is produced, and
   the map data for removal for the failure portion is produced by using the first map data, the second map data, and the topology map data.
[3]: The method for producing a bonded light-emitting device wafer according to [1] or [2], wherein
   after the step of obtaining the bonded light-emitting device wafer, the method further comprises a step of device isolation processing.
[4]: The method for producing a bonded light-emitting device wafer according to [1], wherein
   after the step of obtaining the bonded wafer, and before the step of producing the map data for removal, the method comprises a step of device isolation processing to the light-emitting device structure of the bonded wafer.
[5]: The method for producing a bonded light-emitting device wafer according to [4], wherein
   in the step of producing the map data for the removal,
   a photoluminescence spectrum of the bonded wafer is obtained and then a first map data for the failure portion is produced by using a peak wavelength, a peak intensity, and/or a half width of peak as criteria,
   the bonded wafer is photographed from the to-be-bonded substrate with a CCD camera and then a second map data for the failure portion is produced based on a color tone of an image obtained by the photographing,
   a surface of dice pattern of the light-emitting device structure of the bonded wafer is photographed with a camera, and quality thereof is determined based on deviation from a base pattern to produce an appearance inspection map data,
   the map data for removal for the failure portion is produced by using the first map data, the second map data, and the appearance inspection map data.
[6]: The method for producing a bonded light-emitting device wafer according to any of [1] to [5], wherein
   as the laser light for removal, a laser light having a wavelength of greater than 360 nm and 680 nm or less is used.
[7]: The method for producing a bonded light-emitting device wafer according to any of [1] to [6], wherein
   the laser light for removal is irradiated from either the light-emitting device structure or the to-be-bonded substrate.
[8]: The method for producing a bonded light-emitting device wafer according to any of [1] to [7], wherein
   the adhesive is selected from the group consisting of benzocyclobutene, silicone resin, epoxy resin, SOG, polyimide, and amorphous fluororesin.
[9]: The method for producing a bonded light-emitting device wafer according to any of [1] to [8], wherein
   before removing the portion of the light-emitting device structure that is included in the failure portion, a protective material is coated on the light-emitting device structure.
[10]: The method for producing a bonded light-emitting device wafer according to [9], wherein
   as the protective material, a protective material containing polyvinyl acetate or a protective material containing polyvinyl alcohol is used.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a bonded light-emitting device wafer in which a failure portion is removed, the method comprising the steps of:
obtaining a bonded wafer by bonding a light-emitting device structure, which is to be a micro LED, to a to-be-bonded substrate transparent to laser light for LLO transfer via an adhesive that absorbs the laser light for LLO transfer;
producing map data for removal by optically investigating the failure portion of the bonded wafer; and
obtaining the bonded light-emitting device wafer by irradiating the failure portion of the bonded wafer with the laser light for removal based on the map data for removal, and by sublimating a portion of the light-emitting device structure that is included in the failure portion, thereby removing the portion of the light-emitting device structure that is included in the failure portion.

2. The method for producing a bonded light-emitting device wafer according to claim 1, wherein
in the step of producing the map data for removal,
a photoluminescence spectrum of the bonded wafer is obtained, and then a first map data for the failure portion is produced by using a peak wavelength, a peak intensity, and/or a half width of peak as criteria,
the bonded wafer is photographed from the to-be-bonded substrate with a CCD camera, and then a second map data for the failure portion is produced based on a color tone of an image obtained by the photographing,
a surface of the light-emitting device structure of the bonded wafer is irradiated with a laser light for topology detection from an oblique direction to obtain topology data and then a topology map data for the failure portion based on the topology data is produced, and
the map data for removal for the failure portion is produced by using the first map data, the second map data, and the topology map data.

3. The method for producing a bonded light-emitting device wafer according to claim 1, wherein
after the step of obtaining the bonded light-emitting device wafer, the method further comprises a step of device isolation processing.

4. The method for producing a bonded light-emitting device wafer according to claim 1, wherein
after the step of obtaining the bonded wafer, and before the step of producing the map data for removal, the method comprises a step of device isolation processing to the light-emitting device structure of the bonded wafer.

5. The method for producing a bonded light-emitting device wafer according to claim 4, wherein
in the step of producing the map data for the removal,
a photoluminescence spectrum of the bonded wafer is obtained and then a first map data for the failure portion is produced by using a peak wavelength, a peak intensity, and/or a half width of peak as criteria,
the bonded wafer is photographed from the to-be-bonded substrate with a CCD camera and then a second map data for the failure portion is produced based on a color tone of an image obtained by the photographing,
a surface of dice pattern of the light-emitting device structure of the bonded wafer is photographed with a camera, and quality thereof is determined based on deviation from a base pattern to produce an appearance inspection map data,
the map data for removal for the failure portion is produced by using the first map data, the second map data, and the appearance inspection map data.

6. The method for producing a bonded light-emitting device wafer according to claim 1, wherein
as the laser light for removal, a laser light having a wavelength of greater than 360 nm and 680 nm or less is used.

7. The method for producing a bonded light-emitting device wafer according to claim 1, wherein
the laser light for removal is irradiated from either the light-emitting device structure or the to-be-bonded substrate.

8. The method for producing a bonded light-emitting device wafer according to claim 1, wherein
the adhesive is selected from the group consisting of benzocyclobutene, silicone resin, epoxy resin, SOG, polyimide, and amorphous fluororesin.

9. The method for producing a bonded light-emitting device wafer according to claim 1, wherein
before removing the portion of the light-emitting device structure that is included in the failure portion, a protective material is coated on the light-emitting device structure.

10. The method for producing a bonded light-emitting device wafer according to claim 9, wherein
as the protective material, a protective material containing polyvinyl acetate or a protective material containing polyvinyl alcohol is used.
